# EUROPÄISCHE PATENTSCHRIFT

(11) **EP 0 689 164 B1**
(45) Veröffentlichungstag und Bekanntmachung des Hinweises auf die Patenterteilung: **25.09.2002**
(21) Anmeldenummer: 95109534.8
(22) Anmeldetag: 20.06.1995
(51) Int. Cl.: G06K 19/077, G06K 19/18

(54) **Verfahren zur Herstellung von Datenträgern**
Method for producing recording medium
Méthode de fabrication de parteurs d'information

(30) Priorität: 21.06.1994 DE 4421607
(43) Veröffentlichungstag der Anmeldung: 27.12.1995
(73) Patentinhaber: Giesecke & Devrient GmbH, 81677 München (DE)
(72) Erfinder: Hohmann, Arno, D-81369 München (DE); Hoppe, Joachim, D-81667 München (DE); Haghiri, Yahya, D-80797 München (DE)
(74) Vertreter: Klunker . Schmitt-Nilson . Hirsch

(56) Entgegenhaltungen:
- EP-A- 0 376 062
- EP-A- 0 418 759
- US-A- 4 863 546

## Beschreibung

Die Erfindung betrifft ein Verfahren zur Herstellung eines Halbzeuges aus einer Folienbahn, bestehend aus einer Spulenträgerfolie, auf der eine Spule aus leitendem Material und ein integrieter Schaltkreis, der leitend mit der Spule verbunden ist,aufgebracht sind.

In der Vergangenheit sind verschiedene Ausweiskarten oder andere Datenträger für unterschiedliche Anwendungen bekannt geworden, wie z. B. Bankkarten, Telefonkarten, Krankenversicherungskarten, Betriebsausweise usw. Die Karten sind entsprechend ihrer Verwendung mit unterschiedlichen Elementen versehen. So verfügen Bankkarten z. B. über einen Magnetstreifen, einen Unterschriftsstreifen und ein Hologramm, wohingegen Telefonkarten ein elektronisches Modul aufweisen. Weitere Elemente auf der Oberfläche der Karten sind denkbar. Es gilt jedoch für alle Karten, daß die obengenannten Elemente in einer definierten und zum Teil sogar genormten Position auf dem Kartenkörper plaziert oder in diesen integriert sind.

Die obengenannten Datenträger können nach unterschiedlichen Verfahren hergestellt werden, die grob zwei Gruppen, nämlich der Einzelkarten- bzw. der Mehrnutzenfertigung zugeordnet werden können.

In der Einzelkartenfertigung können die erwähnten Elemente sehr genau positioniert werden, weil jede einzelne Karte in eine genaue Position zu dem Werkzeug gebracht wird, mit Hilfe dessen der Kartenkörper bearbeitet oder mit Zusatzelementen versehen wird. Die Einzelkartenfer tigung wird also bevorzugt dann verwendet, wenn es auf eine sehr genaue Positionierung der Elemente, z. B. gemäß einer Norm ankommt. Neben der hohen Qualität der Datenträger ist jedoch eine hohe Anzahl an fertiggestellten Karten pro Zeiteinheit wünschenswert. In der Einzelkartenfertigung läßt sich dieses Ziel nur durch die Bereitstellung weiterer Fertigungsstraßen erreichen, was einen hohen Kostenaufwand erfordert.

Es wurde deswegen auch schon vorgeschlagen, die Ausweiskarten aus einem Mehrnutzenbogen, bzw. einer Mehrnutzenbahn zu fertigen. Hierbei wird zunächst ein Mehrnutzenbogen bereitgestellt, der in einem bestimmten Rastermaß, entsprechend der Größe der Karten mit einem der obengenannten Elemente, z. B. einem elektronischen Modul versehen wird. Schließlich werden mit einem Stanzwerkzeug die einzelnen Karten aus dem Mehrnutzenbogen ausgestanzt. Die Verwendung von Mehrnutzenbogen läßt also eine rationelle Fertigung von Karten mit positionierten Elementen zu.

Ein optimaler Durchsatz kann jedoch mit Mehrnutzenbogen nur dann erreicht werden, wenn ein Arbeitsvorgang, beispielsweise der Einbau eines elektronischen Moduls mit einem Mehrfachwerkzeug an mehreren Karten im Bogen gleichzeitig durchgeführt werden kann. Dazu ist es notwendig, daß diese Karten gleichzeitig eine genau definierte Position zum Werkzeug einnehmen. Eine solche Positionierung ist aufgrund von Toleranzen im Mehrnutzenbogen nicht immer möglich. Bei der Herstellung von Mehrnutzenlaminaten, die aus mehreren Schichten bestehen, kann auch ein Halbzeug verwendet werden, welches die obengenannten Elemente enthält.

Es ist deshalb Aufgabe der Erfindung, ein Verfahren vorzuschlagen, das eine rationelle Fertigung von Halbzeugen mit applizierten Elementen ermöglicht.

Die Aufgabe wird durch die Merkmale des Anspruchs 1 gelöst.

Im Zusammenhang mit den nachstehenden Figuren werden Ausführungsbeispiele und weitere Vorteile der Erfindung näher erläutert, darin zeigt:
- Fig. 1: einen Datenträger in Aufsicht
- Fig. 2: einen Mehrnutzenbogen in Aufsicht
- Fig. 3: einen schematisierten Verfahrensablauf zur Fertigung von Datenträgern
- Fig. 4: eine Fertigungsstraße für Halbzeuge
- Fig. 5: einen Spulenwickelapparat
- Fig. 6: eine Spule auf einer Trägerfolie
- Fig. 7: ein Verfahren zum Aufbringen einer Spule auf einer Trägerfolie
- Fig. 8: einen Querschnitt durch ein fertiggestelltes Halbzeug.

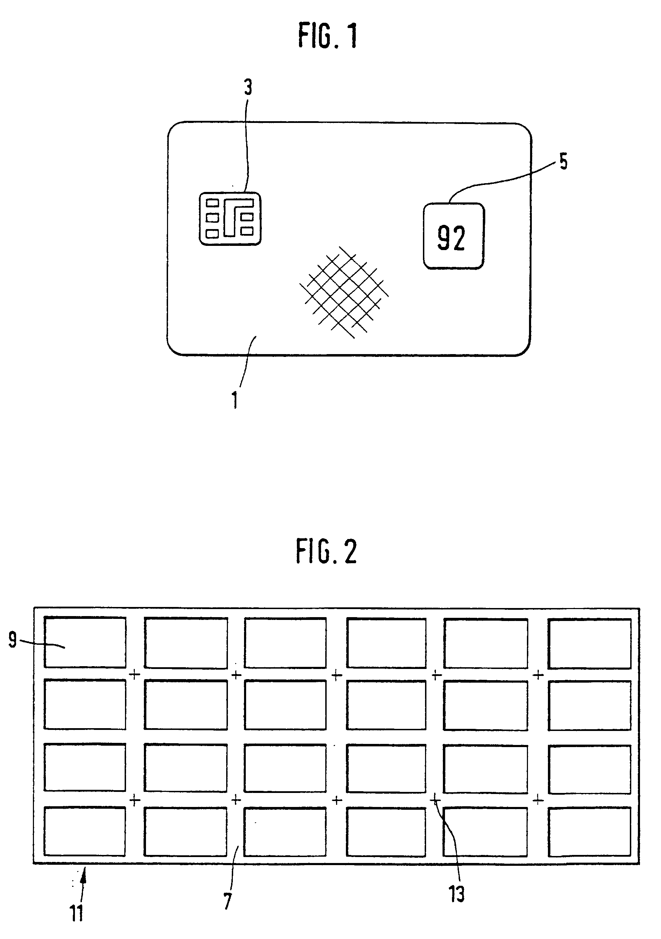

Fig. 1 zeigt einen Datenträger 1 in Aufsicht. Auf solchen Datenträgern können sich je nach Verwendung die verschiedensten Elemente befinden. In der Fig. 1 sind beispielhaft ein elektronisches Modul 3 und ein Hologramm 5 eingezeichnet. Die Position des elektronischen Moduls 3 im Kartenkörper ist durch eine ISO-Norm festgelegt. Auch das Hologramm befindet sich in einer definierten Position im Kartenkörper. Weitere Elemente, die in den Oberflächen von Datenträgern positioniert werden, sind Magnetstreifen, Unterschriftsstreifen, Fotografien usw. Bei der Herstellung der Datenträger ist dafür Sorge zu tragen, daß die Elemente in der richtigen Position in den Kartenkörper eingebracht werden. Für den Einbau eines elektronischen Moduls in den Kartenkörper bedeutet dies beispielsweise, daß die Aussparung, die das elektronische Modul aufnimmt, an der richtigen Stelle mit der richtigen Tiefe erzeugt und daß das elektronische Modul lagerichtig in die Aussparung eingeklebt werden muß.

Fig. 2 zeigt einen Mehrnutzenbogen 7 in Aufsicht, der zumindest einseitig in einem bestimmten Rastermaß (Abstand der einzelnen Druckbilder zueinander) mit Druckbildern der Datenträger versehen ist. Solche Mehrnutzenbogen bzw. Mehrnutzenbahnen sind nicht ohne Toleranzen zu fertigen. Beispielsweise können bei der Herstellung von Mehrnutzenlaminaten, die aus mehreren Schichten bestehen, beim Laminieren Verzüge in den einzelnen Schichten auftreten, was zur Folge hat, daß die Druckbilder 9 der einzelnen Karten, bezogen auf den Mehrnutzenbogen 7, nicht in einem konstanten Rastermaß vorliegen. Aufgrund dessen ist eine-genaue gleichzeitige Plazierung mehrerer Karten des Bogens 7, z. B. der Karten der Reihe 11, zu einem Werkzeug nicht möglich, da im Bogen 7 keine Bezugskante vorhanden ist, die einen definierten Abstand zu allen Karten hat.

Die obengenannten Probleme könnten dadurch vermieden werden, daß man auf große Mehrnutzenbogen gänzlich verzichtet bzw. daß man Werkzeuge, mit denen man mehrere Karten in einem Mehrnutzenbogen gleichzeitig bearbeitet, einzeln positionier- und steuerbar macht. Im ersten Fall muß man jedoch auf den Vorteil der rationellen Fertigung von Mehrnutzenbogen gänzlich verzichten, wohingegen im zweiten Fall die Werkzeuge über komplizierte, teuere Steuermechanismen verfügen müssen.

Deshalb werden möglichst viele Verfahrensschritte, die keine genaue Positionierung von Elementen erfordern, wie beispielsweise das Laminieren und Bedrucken von Schichten, am Mehrnutzenbogen 7 durchzuführen und diesen Bogen 7 dann in kleinere Einheiten zu unterteilen. Diese Einheiten verfügen über Positioniersmarkierungen, die eine genau definierte Position zu mehreren Karten haben. Anhand dieser Positionierungsmarkierungen können mehrere Karten gleichzeitig in eine genaue Position zu einem Mehrfachwerkzeug gebracht und gleichzeitig mit unterschiedlichen Elementen versehen werden. Dazu ist das Mehrfachwerkzeug so ausgebildet, daß sämtliche positionierte Karten gleichzeitig bearbeitet werden können.

Bevorzugt liegen die Positionierungsmarkierungen im Zentrum von jeweils vier Druckbildern der Karten und können als Druckmarkierungen 13 bereits im Gesamtdruckbild des Mehrnutzenbogens enthalten sein (siehe Fig. 2). Es versteht sich für den Fachmann jedoch von selbst, daß die Positionsmarkierungen auch an anderen Stellen, z. B. an den Kanten der kleineren Einheiten, wie bei einem Film, vorgesehen sein können.

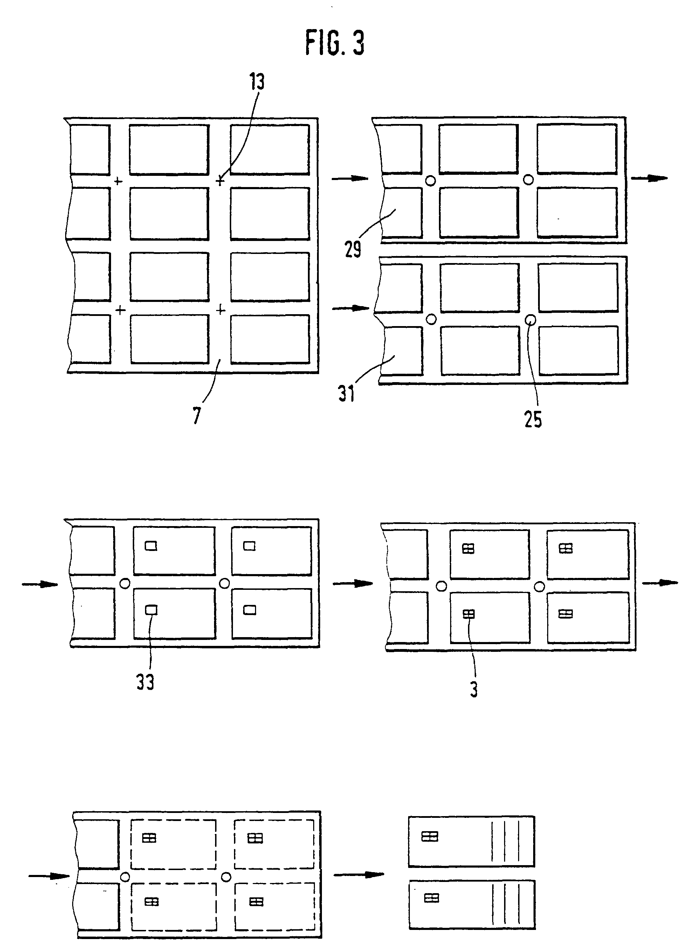

Fig. 3 zeigt schematisiert das Herstellungsverfahren von Datenträgern mit positionierten Elementen, hier mit einem elektronischen Modul. Ein Mehrnutzenbogen 7 gemäß Fig. 2 bzw. eine Mehrnutzenbahn wird in kleinere Einheiten 29 und 31 mit vorzugsweise zwei Kartenreihen unterteilt und mit Positionslöchern 25 im Zentrum von jeweils 4 Karten versehen. Die Positionslöcher 25 werden mit einer Stanze erzeugt, die z. B. mit Hilfe eines optischen Erfassungssystems, das anhand der Druckmarkierungen oder anderer Bezugsgrößen (z. B. den Ecken der Druckbilder der umliegenden Karten) das Zentrum der umliegenden Karten erfaßt, positioniert wird.

Die weitere Verarbeitung wird an den kleineren Einheiten durchgeführt, die mittels der Positionslöcher 25 getaktet zu den weiteren Verarbeitungsstationen transportiert werden. Die Positionierung der aufgedruckten Datenträger der kleinen Einheiten zu einer Verarbeitungsstation erfolgt anhand einer an sich frei wählbaren Bezugskante, die in der kleinen Einheit vorhanden ist. Vorzugsweise wird als Bezugskante jedoch die Verbindungslinie von zwei hintereinanderliegenden Positionslöchern 25 gewählt, da die zu diesen Löchern umliegenden aufgedruckten Datenträger automatisch eine exakate Position zu dieser Bezugskante einnehmen. In diesem Fall greift in jeweils ein Positionsteil ein Transportstift, so daß die Verbindungslinie der Positionslöcher mit der Verbindungslinie der Transportstifte übereinstimmt und die Datenträger somit eine definierte Position zur Transportstrecke haben. Die Datenträger können also getaktet und exakt positioniert zu den Verarbeitungsstationen an der Transportstrecke geführt werden. In den Verarbeitungsstationen können mehrere oder alle exakt positionierten Karten gleichzeitig mit einem entsprechend ausgebildeten Mehrfachwerkzeug bearbeitet werden. In der ersten Verarbeitungsstation werden die vier gezeigten Karten mit einem vierfach ausgebildeten Fräswerkzeug gleichzeitig mit Aussparungen 33 versehen. Hierbei brauchen die Fräsköpfe nicht einzeln gesteuert werden, da sich das gesamte Werkzeug bereits in der richtigen Lage zu den aufgedruckten Karten befindet. Es ist für den Fachmann selbstverständlich, daß eine Aussparung oder ein Fenster in den Karten auch auf andere Weise, z. B. durch Stanzung etc., erzeugt werden kann.

In den folgenden Stationen, in denen die Positionierung immer nach dem gleichen Prinzip erfolgt, werden in die Aussparungen elektronische Module 3 eingesetzt, die Position der elektronischen Module überprüft und Karten mit einem fehlerhaft positionierten Modul gekennzeichnet, die einzelnen Karten mit einem vierfach ausgebildeten Stanzwerkzeug ausgestanzt und schließlich magaziniert. Nach dem gezeigten Verfahren können die Datenträger mit beliebigen Elementen versehen werden.

Das erfindungsgemäße Verfahren dient zur Herstellung von Halbzeugen, die erst später in einen Datenträger integriert werden.

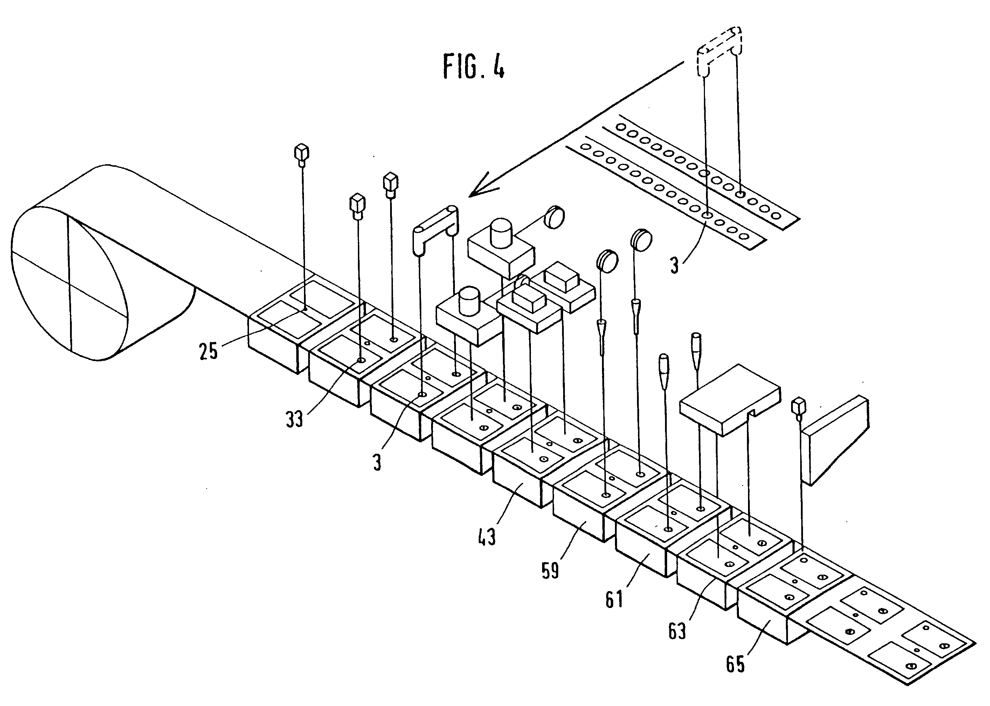

Fig. 4 zeigt die Herstellung einer Datenträgerschicht mit einem elektronischen Modul, das leitend mit einer auf der Kartenschicht befindlichen Spule verbunden ist. Diese Datenträgerschicht kann später in Datenträger, die für den berührungslosen Datenaustausch geeignet sind, eingebaut werden. Zunächst wird wiederum eine Folienrolle gefertigt, die in mehrere Folienbänder, also in kleinere Einheiten unterteilt wird. Die Folienbänder werden in einer ersten Verarbeitungsstation mit Positionslöchern 25 versehen, die eine definierte Position zu den umliegenden Kartenfolien haben. Mit Hilfe dieser Löcher 25 wird das Folienband getaktet zu den weiteren Verarbeitungsstationen transportiert, womit sichergestellt ist, daß sich die umliegenden Kartenfolien in der richtigen Position zum Werkzeug befinden. In der nächsten Station werden Aussparungen 33 in die Folien eingefräst, in die in der darauffolgenden Station elektronische Module 3 eingesetzt werden. In weiteren Stationen werden auf die einzelnen Kartenfolien Spulen aufgebracht und befestigt, was auf verschiedene Art und Weise geschehen kann.

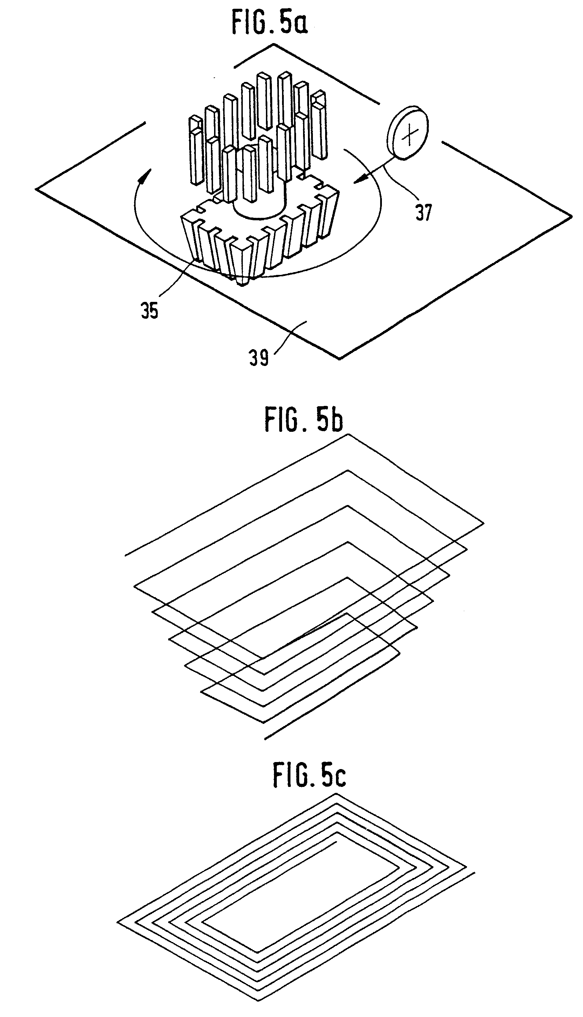

So kann beispielsweise zunächst mit Hilfe eines Spulenwickelapparates eine Spule erzeugt werden, bei der die Spulenwindungen alle in einer Ebene liegen. Ein entsprechender Apparat ist schematisch in Fig. 5a gezeigt. Er besteht aus einem motorisch drehbaren, konisch geformten Wickelkörper 35, der über eine nicht eingezeichnete Haltevorrichtung für den Drahtanfang eines zugeführten Drahtes 37 verfügt. Nachdem der Drahtanfang in der Vorrichtung befestigt worden ist, wird der Wickelkörper n-mal in der eingezeichneten Pfeilrichtung gedreht und mit der Drehbewegung linear gekoppelt abgesenkt, so daß n Drahtwindungen entsprechend Fig. 5b auf dem Wickelkörper aufgewickelt sind. Danach wird das Ende des aufgewickelten Drahtes in eine ebenfalls nicht dargestellte Haltevorrichtung eingespannt und der verbleibende Draht zwischen der Drahtzuführung und der Drahthaltevorrichtung wird durchtrennt. Schließlich wird der Wickelkörper auf die Folie 39 abgesenkt und durch die Abstreifelemente 41 vom Wickelkörper abgestreift und auf die Folie 39 gedrückt. Dadurch entsteht aus der in Fig. 5b gezeigten dreidimensionalen Spule auf der Folie 39 eine Spule, wie sie in der Fig. 5c gezeigt ist. Die derartig auf die Folien aufgebrachten Spulen können in der Station 43 (Fig. 4) beispielsweise durch einen beheizten Stempel, der die Folie erwärmt und die Spulen in die Folien eindrückt, mit der Folie verbunden werden.

Durch die Verwendung des in der Fig. 5a gezeigten Spulenwickelapparates ist es möglich, ebene Spulen zu erzeugen, deren Spulenwindung sich nicht berühren, so wie es in Fig. 5c gezeigt ist. Aus diesem Grunde können für die Spule Drähte verwendet werden, die keine Isolierschicht besitzen. Dies ist dann besonders vorteilhaft, wenn die Spulenenden direkt mit einem integrierten Schaltkreis, z. B. durch Bonden, verbunden werden sollen, da ein Entfernen einer Isolierschicht an den Spulenenden entfällt. Selbstverständlich sind mit dem Spulenwickelapparat aber auch Drähte verarbeitbar, die eine Isolierschicht aufweisen. In diesem Fall kann auf die räumliche Trennung der Spulenwicklungen in der Ebene verzichtet werden.

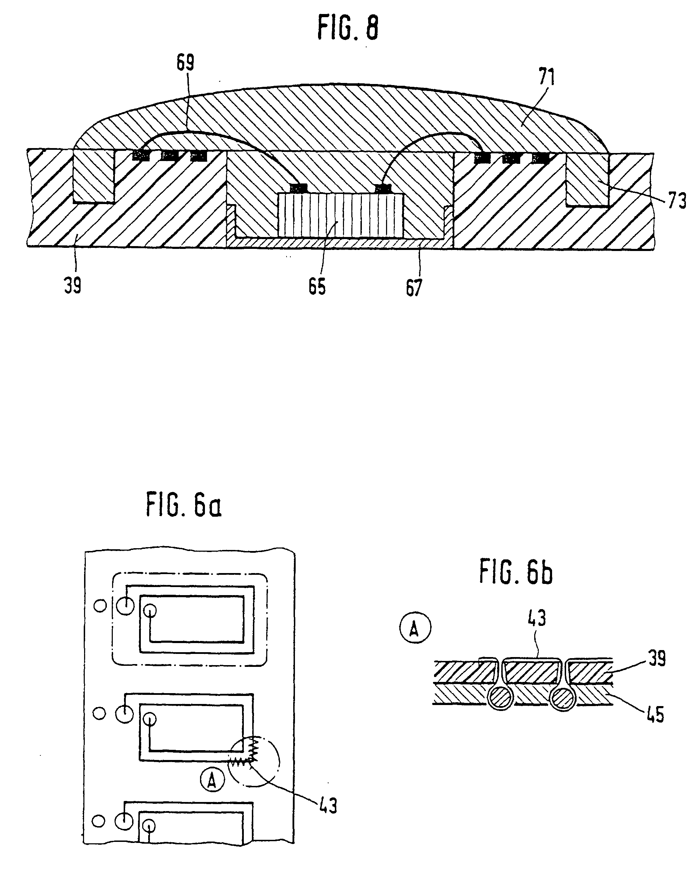

Alternativ ist es allerdings auch möglich, die Spule mit einem Fixierfaden 43, der vorzugsweise aus Kunststoff besteht, auf der Folie zu fixieren, wie es schematisch in den Fig. 6a und 6b gezeigt ist. Der Fixierfaden 43 umläuft den Spulendraht genau so, wie beim herkömmlichen Nähprinzip der Oberfaden den Unterfaden umläuft, die Spule wird also quasi auf der Folie aufgenäht, so wie dies schematisch in der Fig. 6b angedeutet ist. Bei dieser Art der Spulenbefestigung ist es besonders vorteilhaft, wenn anstatt einer Kunststoffolie ein Spulenträger aus Vliesstoff verwendet wird, da man dann beim Umnähen der Spule mit dem Fixierfaden die Spule in den Spulenträger einbetten kann, so daß man einen planen Spulenträger erhält, der später in einen Datenträger eingebaut werden kann und dort keine Deformation hinterläßt. Alternativ kann eine Dickenausgleichfolie 45 verwendet werden, in der der Spulenfaden eingebettet wird.

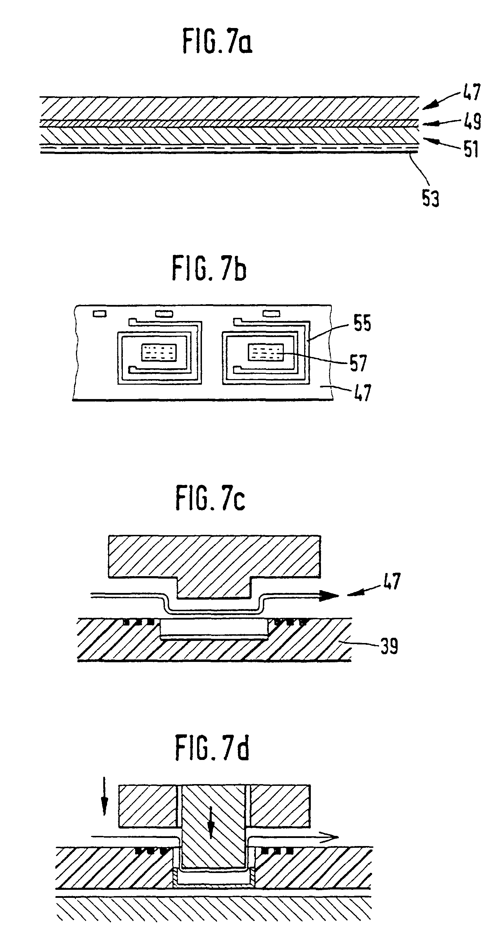

Eine weitere Möglichkeit, die einzelnen Kartenfolien des Mehrnutzenbogens bzw. Mehrnutzenbandes mit Spulen zu bestücken, besteht darin, die Spule im Heißprägeverfahren auf die Kartenfolie aufzubringen. Dazu wird zunächst ein mehrschichtiger Film bereitgestellt (siehe Fig. 7a), der aus einem Trägerfilm 47, einer Trennschicht 49 (z. B. Wachs), einer Schicht 51, die die einzelne Spulen enthält, und einer Heißsiegellackschicht 53 besteht. Fig. 7b zeigt eine Aufsicht auf den mehrschichtigen Film. Die einzelnen Spulen 55 werden aus der leitenden Schicht 51 ausgeätzt oder anderweitig hergestellt und danach mit dem Heißsiegellack besprüht. Zusätzlich zu den Spulen können aus der leitenden Schicht 51 Chipbasen 57 ausgeätzt werden, deren Funktion später erläutert wird.

Der derart vorbereitete mehrschichtige Film wird in Position zu der Kartenfolie 39 gebracht, die bereits über eine Aussparung zur Aufnahme des integrierten Schaltkreises verfügt, wobei der Trägerfilm 47, auf der der Kartenfolie abgewandten Seite des Films liegt (siehe Fig. 7c). Mit einem Heißprägestempel wird die Trennschicht 49 erweicht und die Heißsiegellackschicht 53 aktiviert, so daß die Spule 55 auf die Folie 39 übertragen und der Trägerfilm 47 entfernt werden kann. Zusätzlich kann der Stempeldruck genutzt werden, um die Spule in die Folie 39 einzudrücken. Enthält die Folie 39 anstatt der Aussparung ein Fenster, so wie es in Fig. 7d gezeigt ist, so kann mit Hilfe eines zweiteiligen Prägestempels zunächst die Spule 55 auf die Folie 39 übertragen und danach die Chipbasis in das Fenster eingedrückt werden, so aaß in dem Fenster eine leitende Wanne zur Aufnahme des integrierten Schaltkreises entsteht.

Schließlich kann man die Spule auf die Kartenfolie dadurch aufbringen, daß man zunächst elektrisch leitende Partikel auf die örtlich in Form der herzustellenden Spule statisch aufgeladene Folie aufbringt. Dabei kann die Aufbringung der Partikel ganzflächig erfolgen, wobei die Partikel, die sich an ungeladenen Stellen der Folie befinden, anschließend, z. B. durch einen Luftstrom, entfernt werden. Es ist aber auch möglich, die elektrisch leitenden Partikel örtlich aufzubringen, indem ein Partikelstrom in einem bestimmten Abstand an der geladenen Folie vorbeigeführt wird, wobei sich durch die elektrostatische Anziehung zwischen den Partikeln und den aufgeladenen Stellen der Folie die Partikel an den aufgeladenen Stellen niederschlagen. Zur Verstärkung der elektrostatischen Anziehung zwischen der Folie und den elektrisch leitenden Partikeln können die Partikel zusätzlich umgekehrt zur Folie elektrostatisch aufgeladen werden.

In einen nachfolgenden Verarbeitungsschritt werden die elektrisch leitenden Partikel zu Leiterbahnen verschmolzen und mit der Folie fest verbunden. Dies kann z. B. wiederum in der Station 43 (Fig. 4) mit Hilfe der beheizten Stempel geschehen.

Nachdem auf die Kartenfolien eine Spule aufgesetzt worden ist, wird, wie es in Fig. 5 in der Station 59 angedeutet ist, jeweils ein integrierter Schaltkreis in die Aussparung bzw. in die Chipwanne eingesetzt und über leitende Drähtchen, sogenannte Bonddrähtchen, mit den Spulenenden verbunden.

In den folgenden Stationen 61 und 63 werden die integrierten Schaltkreise zum Schutz vor mechanischen Belastungen mit einer Gußmasse vergossen und auf ihre Funktionsfähigkeit überprüft. Danach werden diejenigen Spulenträger, die einen defekten integrierten Schaltkreis oder andere Fehler aufweisen, in einer Station 65 beispielsweise durch ein gestanztes Loch gekennzeichnet. Schließlich können die fertiggestellten Halbzeuge aus dem Folienband ausgestanzt werden.

Fig. 8 zeigt einen Querschnitt durch ein fertiggestelltes ausgestanztes Halbzeug in einer beispielhaften Ausführungsform. Der integrierte Schaltkreis 65 befindet sich in einer Chipwanne 67 und ist über Bonddrähtchen 69 mit der Spule leitend verbunden. Der integrierte Schaltkreis 65 und die Bonddrähtchen 69 sind zum Schutz vor mechanischen Belastungen mit einer Gußmasse 71 vergossen, die tropfenförmig auf der Folie 39 ausgebildet ist. Als Fließstopp für die Gußmasse kann in der Folie 39 eine Rinne 73 erzeugt werden, beispielsweise mit Hilfe des obengenannten Heißprägestempels.

## Patentansprüche

1. Verfahren zur Herstellung eines Halbzeuges aus einer Folienbahn, bestehend aus einer Spulenträgerfolie, auf der eine Spule aus leitendem Material und ein integrierter Schaltkreis, der leitend mit der Spule verbunden ist, aufgebracht sind, **dadurch gekennzeichnet, daß**
- die Folienbahn in einer ersten Station mit Positionslöchern versehen wird, die zum getakteten Transport und zur Positionierung der Folie zu weiteren Stationen genutzt werden;
- in die Folienbahn in einem bestimmten Rastermaß Aussparungen eingefräst werden, wobei das Rastermaß durch die Größe des Halbzeugs sowie der Position der Spule und des integrierten Schaltkreises vorgegeben ist;
- in die Aussparungen integrierte Schaltkreise eingesetzt und dort befestigt werden;
- auf die Folienbahn in dem bestimmten Rastermaß Spulen derart aufgesetzt und befestigt werden, daß jedem der integrierten Schaltkreise eine Spule zugeordnet ist;
- die integrierten Schaltkreise leitend mit den Spulenenden der ihnen zugeordneten Spulen verbunden werden;
- die integrierten Schaltkreise und die leitenden Verbindungen mit einer Gußmasse vergossen werden.

2. Verfahren zur Herstellung eines Halbzeuges nach Anspruch 1, **dadurch gekennzeichnet, daß** die Spulenwicklungen der auf der Folienbahn aufgebrachten Spulen in einer Ebene liegen und auf der Folienbahn befestigt werden.

3. Verfahren zur Herstellung eines Halbzeuges nach Anspruch 2, **dadurch gekennzeichnet, daß** die Folienbahn erwärmt wird und die Spulen durch Eindrücken in die erwärmte Folienbahn auf dieser befestigt werden.

4. Verfahren zur Herstellung eine Halbzeuges nach Anspruch 2, **dadurch gekennzeichnet, daß** die Spulen mittels eines Fixierfadens nach dem Nähprinzip auf der Folienbahn befestigt werden.

5. Verfahren zur Herstellung eines Halbzeuges nach Anspruch 2, **dadurch gekennzeichnet, daß** die Spulen im Heißprägeverfahren von einem Trägerband auf die Folienbahn übertragen werden.

6. Verfahren zur Herstellung eines Halbzeuges nach Anspruch 2, **dadurch gekennzeichnet, daß** die Teile der Folienbahnen, auf die Spulen aufgebracht werden sollen, in Form der Spule elektrostatisch aufgeladen und mit elektrisch leitenden Partikeln versehen werden, die in einem nachfolgenden Schritt zu Leiterbahnen verschmolzen und mit der Folie fest verbunden werden.

7. Vorrichtung zur Durchführung des Verfahrens nach Anspruch 1, **dadurch gekennzeichnet, daß** sie umfaßt:
- erste Mittel, mit denen die Folienbahn mit Positionslöchern versehen werden kann;
- zweite Mittel, mit denen die Folienbahn in dem bestimmten Rastermaß mit Aussparungen bzw. Fenstern versehen werden kann;
- dritte Mittel, mit denen in die Aussparungen bzw. in die Fenster integrierte Schaltkreise eingesetzt werden können;
- vierte Mittel, mit denen auf die Folienbahn in dem bestimmten Rastermaß Spulen auf die Folienbahn aufgebracht werden können;
- fünfte Mittel, mit denen die integrierten Schaltkreise mit jeweils einer Spule elektrisch leitend verbunden werden;
- sechste Mittel, mit denen Folienteile aus der Folienbahn entfernt werden können,die jeweils einen integrierten Schaltkreis und eine Spule enthalten.

8. Vorrichtung nach Anspruch 7, **dadurch gekennzeichnet, daß** zumindest die zweiten bis sechsten Mittel so ausgeführt sind, daß jeweils zwei oder mehr Fclienteile gleichzeitig bearbeitet werden können.

## Claims

1. A method for producing a semifinished product from a foil web including a coil carrier foil having applied thereto a coil of conductive material and an integrated circuit electrically connected with the coil, **characterized by** the steps of
- providing the foil web in a first station with position holes which are utilized for clocked transport to, and positioning the foil at, further stations;
- milling recesses into the foil web at a certain grid distance, the grid distance being given by the size of the semifinished product and the position of the coil and integrated circuit;
- inserting integrated circuits into the recesses and fastening them there;
- mounting and fastening coils on the foil web at the certain grid distance such that each of the integrated circuits has a coil associated therewith;
- electrically connecting the integrated circuits with the coil ends of the associated coils;
- casting the integrated circuits and the electric connections with a casting compound.

2. A method for producing a semifinished product according to claim 1, **characterized in that** the turns of the coil applied to the foil web are in one plane and fastened to the foil web.

3. A method for producing a semifinished product according to claim 2, **characterized in that** the foil web is heated and the coils are pressed into the heated foil web to be fastened thereto.

4. A method for producing a semifinished product according to claim 2, **characterized in that** the coils are fastened to the foil web by means of a fixing thread on the sewing principle.

5. A method for producing a semifinished product according to claim 2, **characterized in that** the coils are transferred to the foil web from a carrier band by the hot-stamping method.

6. A method for producing a semifinished product according to claim 2, **characterized in that** the parts of the foil webs to which coils are to be applied are charged electrostatically in the form of the coil and provided with electrically conductive particles which are fused into conductive paths and firmly connected with the foil in a following step.

7. An apparatus for carrying out the method according to claim 1, **characterized in that** it includes:
- first means for providing the foil web with position holes;
- second means for providing the foil web with recesses or windows at the certain grid distance;
- third means for inserting integrated circuits into the recesses or windows;
- fourth means for applying coils to the foil web at the certain grid distance;
- fifth means for electrically connecting the integrated circuits with one coil each;
- sixth means for removing foil parts from the foil web which each contain an integrated circuit and a coil.

8. An apparatus according to claim 7, **characterized in that** at least the second to sixth means are executed such that two or more foil parts can be processed at the same time.

## Revendications

1. Procédé de fabrication d'un produit semi-fini à partir d'une feuille sous forme de film continu, composé d'une feuille de support de bobine sur laquelle sont appliqués une bobine en un matériau conducteur et un circuit intégré qui est relié de façon conductrice à la bobine, **caractérisé en ce que**
- la feuille sous forme de film continu est munie dans une première station, d'ouvertures de positionnement utilisées pour le transport selon un rythme déterminé et pour le positionnement de la feuille au niveau d'autres stations ;
- dans la feuille sous forme de film continu, selon une dimension modulaire déterminée, des évidements sont formés par fraisage, la dimension modulaire étant prédéterminée en fonction de la taille du produit semi-fini et de la position de la bobine et du circuit intégré ;
- dans les évidements, des circuits intégrés sont insérés et fixés ;
- sur la feuille sous forme de film continu, dans la dimension modulaire déterminée des bobines sont appliquées et fixées de sorte qu'une bobine soit associée à chacun des circuits intégrés ;
- les circuits intégrés sont reliés de façon conductrice aux extrémités de bobine des bobines qui leur sont associées ;
- une masse d'enrobage est coulée sur les circuits intégrés et les liaisons conductrices.

2. Procédé de fabrication d'un produit semi-fini selon la revendication 1, **caractérisé en ce que** les enroulements des bobines appliquées sur la feuille sous forme de film continu sont disposées dans un plan et sont fixés à la feuille sous forme de film continu.

3. Procédé de fabrication d'un produit semi-fini selon la revendication 2, **caractérisé en ce que** la feuille sous forme de film continu est chauffée et les bobines sont fixées à cette dernière en les enfonçant dans la feuille sous forme de film continu réchauffée.

4. Procédé de fabrication d'un produit semi-fini selon la revendication 2, **caractérisé en ce que** les bobines sont fixées à la feuille sous forme de film continu au moyen d'un fil de fixation selon le principe de la couture.

5. Procédé de fabrication d'un produit semi-fini selon la revendication 2, **caractérisé en ce que** les bobines sont transférées selon un procédé d'empreinte à chaud à partir d'une bande de support sur la feuille sous forme de film continu.

6. Procédé de fabrication d'un produit semi-fini selon la revendication 2, **caractérisé en ce que** les parties de la feuille sous forme de film continu sur lesquelles les bobines doivent être appliquées, sont chargées électriquement sous forme de la bobine et sont munies de particules conductrices de l'électricité qui, dans une phase ultérieure, sont fondues pour former des pistes conductrices et reliées de façon fixe à la feuille.

7. Dispositif pour la mise en oeuvre du procédé selon la revendication 1, **caractérisé en ce qu'**il comprend:
- des premiers moyens avec lesquels la feuille sous forme de film continu peut être munie d'ouvertures de positionnement ;
- des deuxièmes moyens, avec lesquels la feuille sous forme de film continu peut être munie, selon une dimension modulaire déterminée, d'évidements, ou, respectivement, de fenêtres ;
- des troisièmes moyens avec lesquels des circuits intégrés peuvent être insérés dans les évidements, ou, respectivement, les fenêtres ;
- des quatrièmes moyens permettant d'appliquer des bobines sur la feuille sous forme de film continu selon la dimension modulaire déterminée ;
- des cinquièmes moyens pour relier électriquement chaque circuit intégré avec une bobine respective ;
- des sixièmes moyens permettant d'enlever des parties de feuille contenant chacune un circuit intégré et une bobine, de la feuille sous forme de film continu.

8. Dispositif selon la revendication 7, **caractérisé en ce qu'**au moins les deuxièmes jusqu'aux sixièmes moyens sont réalisés de sorte que, dans chaque cas, deux ou plusieurs parties de feuilles peuvent être traitées simultanément.
